Europäisches Patentamt

European Patent Office

Office européen des brevets

(11) Publication number: **0 088 179**
**B1**

# EUROPEAN PATENT SPECIFICATION

(45) Date of publication of patent specification: **02.03.88**

(51) Int. Cl.⁴: **H 01 L 29/91**

(21) Application number: **82304718.8**

(22) Date of filing: **08.09.82**

(54) Transient absorption semiconductor device.

(30) Priority: **09.03.82 GB 8206881**
**24.06.82 GB 8218361**

(43) Date of publication of application:
**14.09.83 Bulletin 83/37**

(45) Publication of the grant of the patent:
**02.03.88 Bulletin 88/09**

(84) Designated Contracting States:
**AT BE CH DE FR GB IT LI LU NL SE**

(56) References cited:
**FR-A-1 576 940**
**GB-A-1 447 763**
**US-A-4 262 295**

(73) Proprietor: **SEMITRON CRICKLADE LTD.**
**Cricklade Swindon**
**Wiltshire SN6 6HQ (GB)**

(72) Inventor: **Hempleman, Mirka**
**14/16 Widham Purton**
**Swindon Wiltshire (GB)**
Inventor: **Howard, Christopher George**
**Priory Cottage**
**Wootton Bassett Wiltshire (GB)**

(74) Representative: **Mehl, Ernst, Dipl.-Ing. et al**
**Postfach 22 01 76**
**D-8000 München 22 (DE)**

Courier Press, Leamington Spa, England.

## Description

This invention relates to a transient absorption semiconductor device, for presenting a relatively high impedance over a given range of applied voltage and for presenting a low impedance in response to transient voltage excursions from the given range, the device having particular application as a protection device in an electrical circuit, for protecting the circuit by selectively conducting transient surges in current flowing in the circuit.

It is known that a PN junction in a semiconductor body can be used to protect an electrical circuit from transient voltage surges. The PN junction is connected across a voltage supply to the circuit such as to be reverse biased. The breakdown voltage of the reverse biased junction is selected to be somewhat greater than the voltage normally developed by the supply. Thus in normal use, the junction does not conduct substantially but in the event of a transient voltage surge which results in the supply voltage exceeding the breakdown voltage, the reverse biased junction breaks down and conducts the current surge associated with the voltage surge, so as to protect the circuit from the surge. The breakdown voltage is typically in the range 2—1000V the value thereof being selected for the junction concerned by control of the doping levels utilised in manufacture of the junction. For higher voltages in the aforementioned range of breakdown voltages the breakdown occurs by virtue of the Avalanche effect whereas at lower voltages the Zener effect may predominate.

Typically the current flowing in the reverse biased junction prior to breakdown is of the order of 1—10 μA whereas after breakdown, heavy current surges with peak currents of 25 amps or more may flow. The junction does exhibit a finite impedance upon breakdown and the voltage across the broken down junction increases steadily with increased current flow through the junction. Thus, heavy current surges cause heating of the junction and this limits the surge current handling capacity of the device. The current handling capacity can be increased by mounting the junction in a heat dissipating capsule but with the disadvantage of increasing the bulk of the device and making it unsuitable for direct mounting on a printed circuit board. Also, because of the finite impedance of the broken down junction, the voltage across the device rises above the voltage occurring at breakdown as the current increases and the voltage may rise to a level which is unsafe for the circuit being protected.

For protecting an a.c. circuit, it is known to connect two such transient absorption devices in series with their polarities arranged in opposite senses, so that the PN junctions are respectively reverse biased by positive and negative going portions of the a.c. waveform. The junctions thus respectively provide surge protection for positive and negative going voltage transients. It is known also to integrate the two junctions into a single package, either by electrically connecting together two PN junctions, or by taking a P type substrate and doping N type regions into opposite surfaces thereof, so as to form the two PN junctions. On breakdown of either of the junctions, the device exhibits the aforementioned characteristic of increased high voltage with increasing surge current and thus suffers from the disadvantages hereinbefore mentioned.

In US—A—4 262 295, there is described a device according to the first part of claim 1, which shows a rather complicated structure of two integrated NPN elements connected in parallel and having different avalanche breakdown voltages. These elements result either from a variation of the width or of the resistance of a common base layer across the semiconductor body.

The present invention provides an improved transient absorption semiconductor device in which the aforementioned disadvantages are at least substantially reduced.

According to the present invention there is provided a transient absorption semiconductor device comprising a thin planar silicon body (1) of P-conductivity type having two regions (2, 3) of N-conductivity type doped from opposite sides thereof so as to define two spaced apart rectifying junctions (5, 6) with the intermediate P-type region (4), each region (2, 3, 4) having a uniform thickness across said body, and two electrodes (7a, 7b, 8a, 8b) so arranged that when a potential difference is applied thereto one of the junctions (5, 6) is forward biased and the other junction is reverse biased, whereby upon breakdown of the reverse biased junction and with an increase in the magnitude of the current flowing through the device the magnitude of the potential difference developed across the electrodes (7a, 7b, 8a, 8b) decreases from that which causes the breakdown but does not decrease to a value less than a given non-zero value, the device characterized in that the P-type region (4) is homogeneously doped and the junctions (5, 6) are disposed closely so as to interact with the result that majority carriers injected from the forward biased junction are swept into the reverse biased junction in greater numbers with increasing surge current modifying the characteristics of the broken down junction so that the potential difference does not decrease below the given non-zero value.

Those skilled in the art will readily be able to determine from the following explanations and by routine trial and experiment suitable junction configurations and doping levels which produce this decrease in voltage upon breakdown of the reverse biased junction. We have found by experiment that the junctions should be placed closer to one another than in a comparable example of the aforementioned prior art two junction a.c. device and we postulate that this results in majority carriers from the formed biased junction being swept into the reverse biased junction, in greater numbers with increased surge current, so as to modify the characteristics of the broken down junction and produce the decreasing voltage characteristic which characterizes the present invention.

The device according to the invention has the advantage that because its voltage decreases to a given level after breakdown, the heat generated in the device by a surge current is reduced and the surge current handling capability of the device is correspondingly greater than in a comparable example of the aforementioned prior art devices. The device further has the significant and substantial advantage that when coupled in parallel with a circuit for protecting the same from overvoltage surges, the fact that the voltage developed across the device decreases below the device breakdown voltage (which by definition must be below the maximum voltage sustainable by the circuit which the device protects) when the device operates to divert a surge from the protected circuit ensures that throughout the duration of the surge the protected circuit is never subjected to a voltage which is even as high as the device breakdown voltage; in the prior art devices, the voltage developed across the device during a surge rises above the device breakdown voltage and, unless the device breakdown voltage is set at a level significantly lower than the maximum voltage sustainable by the circuit, can exceed the safe circuit voltage. The device according to the invention thus provides a much more precise and definable protective function than has hitherto been obtainable with prior art devices.

Whilst, as will hereinafter be discussed, variation of one or more of the manufacturing parameters of the device according to the invention enables devices to be manufactured consistently and reliably with breakdown voltages within a relatively wide range and up to relatively high values of the order of 150 to 200 volts for example, for applications in the higher voltage areas the invention further proposes, rather than the provision of a single device, to couple together in series two or more devices each of a lower breakdown voltage rating. The resultant composite device has a breakdown voltage substantially corresponding to the sum of the breakdown voltages of the individual devices of the composite multi-device structure.

The invention further provides for two such devices according to the teachings hereof to be electrically contacted with one another and with an electrode formed at the contact therebetween; such a combination device can be used with advantage to replace a conventional gas discharge tube surge arrester for example to protect a pair of telephone lines and their associated circuits against surges.

In order that the invention may be more fully understood embodiments thereof and their operating characteristics will now be described by way of illustrative example and by way of contrast with a prior art device, reference being had to the accompanying drawings wherein:

Figure 1 includes an enlarged sectional view of a device according to the invention;

Figure 2 is a graph of the voltage/current characteristic of the device of Figure 1, contrasted with the characteristic of a prior art device; and

Figure 3 shows a combination device comprising two devices substantially in accordance with Figure 1.

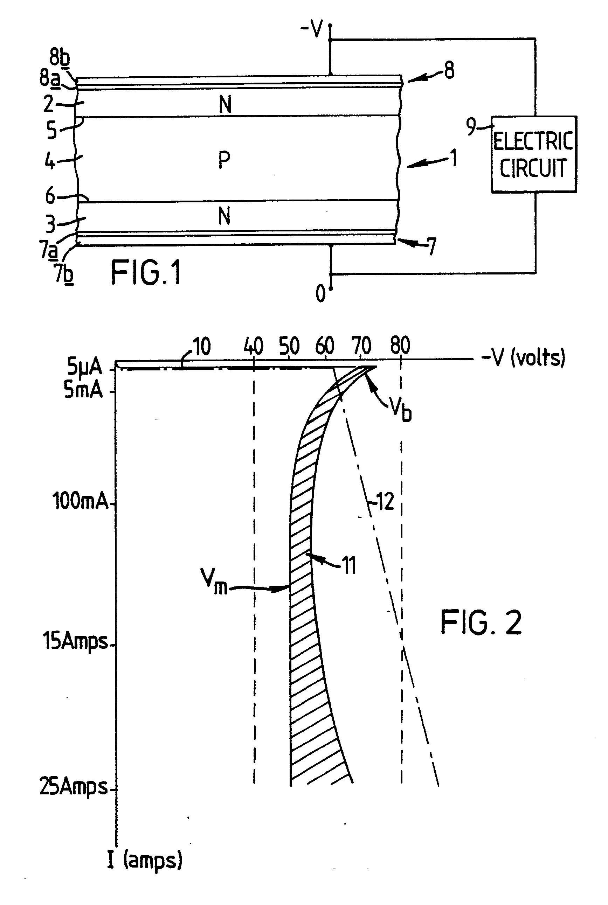

Referring to Figure 1, the transient absorption semiconductor device comprises a thin planar body 1 of P-type silicon of thickness of the order of 200 μm for example doped from opposite sides to provide first and second N-type regions 2, 3 of a depth of the order of 30 μm for example on either side of a P-type region 4. This arrangement thus provides first and second PN junctions shown schematically at 5, 6 arranged in series and with opposite polarities. Electrode layers 7, 8 are formed on opposite sides of the body 1, and it will be appreciated that when a potential difference is applied to the electrodes one of the junctions 5, 6 will be forward biased and the other will be reverse biased.

The device is shown connected to a supply voltage source −V, and is arranged to protect an electric circuit 9. The circuit 9 has maximum and minimum safe rail voltages and the voltage supply −V must not be allowed to vary outside of these maximum and minimum values. For the purposes of this example, it will be assumed that the maximum and minimum safe voltages are 80V and 40V. Also, it will be assumed that the supply voltage −V is from a d.c. source, although the device of the invention will work also with an a.c. source, as will become apparent hereinafter.

Now, referring to Figure 2, a typical device according to the invention will have a V/I characteristic within the region defined by the continuous line and the hatched area on the graph. For an applied voltage −V up to a given breakdown voltage $V_b$, the current flowing through the device is the device leakage current which is very small, for example 5 μA, as shown at 10 and this has no significant effect on the operation of the circuit 9 being protected. In this situation the PN junction 5 is forward biased, and the junction 6 is reverse biased but not such as to exceed its breakdown voltage.

When a voltage transient occurs in the supply voltage V, such as to apply to the device a voltage exceeding $V_b$, the reverse biased junction 6 breaks down and conducts by means of the Avalanche effect. Consequently, the device according to the invention then provides a conductive path for surge currents produced by the voltage transient, and the surge currents thus by-pass the circuit 9 to prevent it being damaged. The V/I characteristic when breakdown occurs is indicated by the hatched area 11. It will be seen that as the surge current increases, the voltage developed across the device rapidly reduces from the device breakdown voltage $V_b$ to a predetermined non-zero value $V_m$ and as the current increases further, the voltage remains at the value $V_m$ at least over a considerable range of surge current. It is to be noted that on the graph, the axis representing current I has a non-linear scale. The voltage reduces to $V_m$ when the current increases to approximately 100 mA in this example, and thereafter remains at or approximately at $V_m$ over a

large range of current values, typically up to 25 amps of peak current for the transient depending upon the physical size of the device, it being appreciated that a device configured about a relatively small silicon body will saturate sooner than the corresponding device configured about a larger silicon body.

The voltage $V_m$ may be selected by means of control of the doping process used to make the device and principally by control of the proximity to one another of the two PN junctions by control of the dopant diffusion depths and will be selected in dependence upon the characteristics of the circuit 9 to be in excess of the minimum safe supply voltage for the circuit 9. Thus in the example given $V_m$ may for example be selected to be 50V, i.e. 10 volts greater than the minimum safe supply voltage of 40V for the circuit 9.

The V/I characteristic of a typical conventional comparable reverse biased PN junction device is shown by the broken line 12 of Fig. 2. The line 12 is illustrative of the V/I characteristic not only of a single PN junction but also of an integrated two junction device of the prior art type previously described, since in the prior art the junctions of the integrated device function independently of one another for different polarity surges. For the illustrative prior art device, the reverse biased junction breaks down at 60 volts to provide a path for the current surge, but as the surge current increases so the voltage steadily increases also. Not only is the voltage developed across the prior art device likely to increase to exceed the maximum safe level for the circuit 9, but also the heat generated in the prior device (which is a function of V × I) will be considerably greater than in the device of the invention, since the device according to the invention operates at lower voltages upon breakdown. Thus the device according to the invention not only serves the protective function more effectively but also it can be made smaller and/or with a less bulky heat dissipating encapsulation.

It is believed that the device according to the present invention exhibits the reducing voltage characteristic 11 by virtue of majority carriers from the forward biased junction 5 being swept into the junction region 6 and altering the conduction characteristics of the junction 6 after breakdown thereof. It has been found that the characteristic 11 is achieved when the PN junctions are disposed closer to one another than in a comparable integrated two junction device of the prior art, presumably allowing the majority charge carriers from the forward biased junction to migrate into the reverse biased junction and recombine therein.

The values of $V_b$ and $V_m$ and also the shape of a particular device characteristic within the area 11 of Fig. 2 can be selected by appropriate control of doping and selection of materials and dimensions during the process of manufacture of devices according to the invention. The semiconductor body 1 conveniently comprises a (111) P-type silicon slice doped on both sides with an N-type dopant such as phosphorous, though alternative crystal orientations could be employed. Also a different dopant than phosphorous could be used, though phosphorous is particularly convenient on account of its ease of use and the reliability and consistency of the results. The breakdown voltage of the device is largely dependant upon the bulk resistivity of the silicon body with resistivities within the range 0.95 to 1.8 $\Omega$ cm$^{-3}$ providing $V_b$ values of the order of 60 volts to 90 to 95 volts which are currently considered most useful in protective applications of the device. Lower resistivity material could be used to obtain lower $V_b$ values, but there is a limit to the low end resistivities on account of the correspondingly decreased charge carrier lifetime in the material which reduces the availability of free carriers to produce the junction interaction which characterizes the present invention. Likewise, higher resistivities for example of the order of 5 or 6 $\Omega$cm$^{-3}$ could be used to obtain devices with $V_b$ values around 200 volts but, as previously mentioned herein and as will be further described hereinafter, for such high voltage applications it is considered preferable to series connect a number of lower voltage devices. The value of $V_m$ is principally a function of the closeness of the two PN junctions in the device which in turn is a function of the thickness of the semiconductor body and the depth of diffusion of the junction forming regions; for example using (111) P-type silicon of thickness 220 μm (8.5 thou) and diffusing phosphorous to provide N-type regions to a depth of 30 μm (1.5 thou) and such that after doping the surface resistance of the N-type regions was around 0.7 to 0.9 $\Omega$ cm$^{-2}$, $V_m$ values of the order depicted in Figure 2 were reliably obtained.

The electrodes preferably are formed as two layer structures 7a, b, 8a, b. The layers 7a, 8a comprise plated deposited Ni, onto which is plated Au layers 7b, 8b. The resulting device can then be mounted between heat dissipating electrodes and encapsulated in a container suitable for direct mounting on a printed circuit board.

It will be appreciated that the described device is symmetrical in construction so that if the supply voltage V is reversed in polarity, junction 6 becomes forward biased and junction 5 reverse biased. The device thus will operate for both polarities of applied voltage and can therefore be used in both a.c. and d.c. circuits.

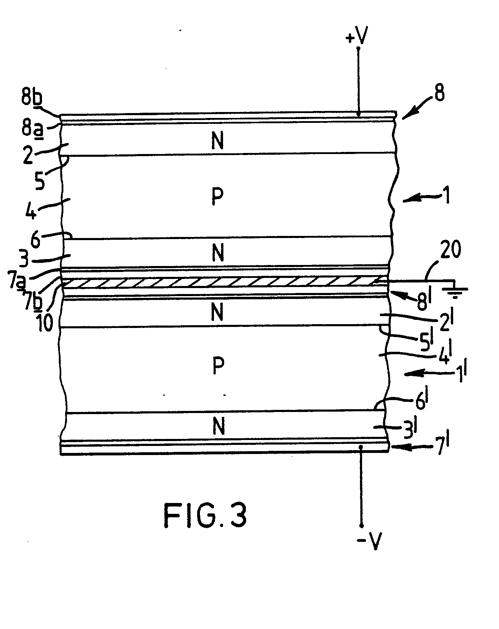

Referring now to Figure 3, there is shown therein a device which essentially comprises two of the transient absorption semiconductor devices 1 of Figure 1 held in contact with one another by a layer of solder 10. In the embodiment of Figure 3 an electrode 20 is further connected to the solder layer 10 for the purpose described hereinafter. The two devices in Figure 3 are marked with the same reference numerals as are used in Figure 1 to designate like parts with the references for the second of the devices each being marked with a prime, i.e. 1'. Each of the devices 1, 1' operates as described above in connection with Figures 1 and 2. The resulting three-terminal structure is particularly suited for use as a replacement component for a conventional gas discharge tube used for surge protection on telephone lines. The +V and −V electrodes are connected to positive and negative lines of a telephone cable and the centre electrode 20 is connected to earth. The three terminal device of Figure 3 thus provides bidirectional surge protection in respect of voltage surges on either of the positive or negative lines of the telephone cable. The device can be suitably encapsulated and may typically be of a suitable size for mounting on a printed circuit board.

A device similar in construction to that of Figure 3 but without the centre electrode would be useful in that, as aforementioned, the breakdown voltage $V_b$ and the fold-back voltage $V_m$ of such a two component device would equal the sum of the respective voltages of the individual devices. A composite device with a $V_b$ of 200 volts and a $V_m$ of 150 volts, for example, thus would comprise two individual devices coupled together with $V_b$ for each device being 100 volts and $V_m$ being 75 volts. A high voltage device can, by this means, be more conveniently manufactured from a number of lower voltage devices than it can be manufactured as a sole device. It is of course also to be appreciated that such a composite device could comprise three or four or even more of the individual devices of Figure 1 series connected with one another.

## Claims

1. A transient absorption semiconductor device comprising a thin planar silicon body (1) of P-conductivity type having two regions (2, 3) of N-conductivity type doped from opposite sides thereof so as to define two spaced apart rectifying junctions (5, 6) with the intermediate P-type region (4), each region (2, 3, 4) having a uniform thickness across said body, and two electrodes (7a, 7b, 8a, 8b) so arranged that when a potential difference is applied thereto one of the junctions (5, 6) is forward biased and the other junction is reverse biased, whereby upon breakdown of the reverse biased junction and with an increase in the magnitude of the current flowing through the device the magnitude of the potential difference developed across the electrodes (7a, 7b, 8a, 8b) decreases from that which causes the breakdown but does not decrease to a value less than a given non-zero value, the device characterized in that the P-type region (4) is homogeneously doped and the junctions (5, 6) are disposed closely so as to interact with the result that majority carriers injected from the forward biased junction are swept into the reverse biased junction in greater numbers with increasing surge current modifying the characteristics of the broken down junction so that the potential difference does not decrease below the given non-zero value.

2. A transient absorption semiconductor device as claimed in claim 1, characterized in that the N-type dopant comprises phosphorus.

3. A transient absorption semiconductor device as claimed in claims 1 or 2, characterized in that the thin planar body (1) has a thickness of the order of 200 µm and the opposite N-type regions (2, 3) each extend to a depth of the order of 30 µm into the planar body.

4. A transient absorption semiconductor device as claimed in any of claims 1 to 3, characterized in that the P-type silicon (4) has a bulk resistivity within the range 0,95 to 1,8 $\Omega$ cm$^{-3}$ and the surface resistivity of the N-type regions (2, 3) is within the range 0,7 to 0,9 $\Omega$ cm$^{-2}$.

5. A transient absorption semiconductor device as claimed in any of claims 1 to 4, characterized by the combination with at least one further such device (1') connected in series with the first device (1).

6. A transient absorption semiconductor device as claimed in claim 5, characterized by two such connected devices (1, 1'), a third electrode (10) being formed between electrically contacting regions (7a, 7b, 8') of the N-type regions (3, 2') of the two devices (1, 1').

## Patentansprüche

1. Überspannungen absorbierende Halbleiteranordnung umfassend einen dünnen planaren Siliciumkörper (1) vom P-Leitungstyp mit zwei von seinen gegenüberliegenden Seiten so dotierten Zonen (2, 3) vom N-Leitungstyp, daß zwei voneinander beabstandete gleichrichtende Übergänge (5, 6) mit der dazwischenliegenden Zone (4) vom P-Typ gebildet werden, wobei jede Zone (2, 3, 4) über den Körper eine gleichmäßige Dicke besitzt, und zwei derart angeordneten Elektroden (7a, 7b, 8a, 8b), daß beim Anlegen einer Potentialdifferenz an diese einer der Übergänge (5, 6) in Durchlaßrichtung und der andere Übergang in Sperrichtung gepolt ist, wodurch beim Durchbruch des in Sperrichtung gepolten Überganges und mit Zunahme der Größe des durch die Anordnung fließenden Stromes die Größe der zwischen den Elektroden (7a, 7b, 8a, 8b) auftretenden Potentialdifferenz gegenüber der den Durchbruch hervorrufenden abnimmt, jedoch nicht auf einen Wert, der kleiner ist als ein vorgegebener von Null verschiedener Wert, dadurch gekennzeichnet, daß die Zone (4) vom P-Typ homogen dotiert ist und die Übergänge (5, 6) so nahe aneinander angeordnet sind, daß sie mit dem Ergebnis zusammenwirken, daß aus dem in Durchlaßrichtung gepolten Übergang injizierte Majoritätsträger mit zunehmendem Überstrom in größerer Zahl in den in Sperrichtung gepolten Übergang geschwemmt werden und die Kennlinie des durchgebrochenen Überganges derart verändern, daß die Potentialdifferenz nicht unter den vorgegebenen, von Null verschiedenen Wert abnimmt.

2. Überspannungen absorbierende Halbleiteranordnung nach Anspruch 1, dadurch gekennzeichnet, daß der Dotierstoff vom N-Typ Phosphor umfaßt.

3. Überspannungen absorbierende Halbleiteranordnung nach Anspruch 1 oder 2, dadurch gekennzeichnet, daß der dünne planare Körper (1) eine Dicke in der Größenordnung von 200 μm besitzt und jeder der einander gegenüberliegenden Zonen (2, 3) vom N-Type sich bis zu einer Tiefe in der Größenordnung von 30 μm in den planaren Körper erstreckt.

4. Überspannungen absorbierende Halbleiteranordnung nach einem der Ansprüche 1 bis 3, dadurch gekennzeichnet, daß das P-Type Silicium (4) einen Volumenwiderstand im Bereich von 0,95 bis 1,8 Ohm × cm$^{-3}$ besitzt und der Oberflächenwiderstand der Zonen (2, 3) vom N-Typ im Bereich von 0,7 bis 0,9 Ohm × cm$^{-2}$ liegt.

5. Überspannungen absorbierende Halbleiteranordnung nach einem der Ansprüche 1 bis 4, gekennzeichnet durch die Kombination mit wenigstens einer in Serie zu der ersten Anordnung (1) geschalten weiteren solchen Anordnung (1′).

6. Überspannungen absorbierende Halbleiteranordnung nach Anspruch 5, gekennzeichnet durch zwei derart verbundene Anordnungen (1, 1′), wobei zwischen den elektrisch in Kontakt stehenden Bereichen (7a, 7b, 8′) der Zonen (3, 2′) vom N-Type der beiden Anordnungen (1, 1′) eine dritte Elektrode (10) gebildet ist.

**Revendications**

1. Un dispositif semiconducteur d'absorption de transitoires comprenant un bloc de silicium plan et mince (1) de conductivité de type P comportant deux régions (2, 3) de conductivité de type N, dopées à partir de ses côtés opposés de façon à définir deux jonctions redresseuses mutuellement espacées (5, 6) avec la région de type P intermédiaire (4), chaque région (2, 3, 4) ayant une épaisseur uniforme sur l'étendue du bloc, et deux électrodes (7a, 7b, 8a, 8b) disposées de façon que lorsqu'une différence de potentiel leur est appliquée, l'une des jonctions (5, 6) soit polarisée en direct et l'autre jonction soit polarisée en inverse, grâce à quoi sous l'effet du claquage de la jonction polarisée en inverse et en présence d'une augmentation de l'intensité du courant qui traverse le dispositif, la valeur de la

différence de potentiel qui apparaît entre les électrodes (7a, 7b, 8a, 8b) diminue à partir de la valeur qui provoque le claquage, mais ne diminue pas jusqu'à une valeur inférieure à une valeur non nulle donnée, ce dispositif étant caractérisé en ce que la région de type P (4) est dopée de façon homogène, et en ce que les jonctions (5, 6) sont disposées à faible distance l'une de l'autre de façon à interagir, ce qui fait que des porteurs majoritaires injectés à partir de la jonction polarisée en direct sont entraînés en nombres croissants dans la jonction polarisée en inverse sous l'effet d'une surintensité de valeur croissante, ce qui modifie les caractéristiques de la jonction dans l'état de claquage de façon que la différence de potentiel ne diminue pas au-dessous de la valeur non nulle donnée.

2. Un dispositif semiconducteur d'absorption de transitoires selon la revendication 1, caractérisé en ce que le dopant de type N consiste en phosphore.

3. Un dispositif semiconducteur d'absorption de transitoires selon les revendications 1 ou 2, caractérisé en ce que le bloc plan et mince (1) a une épaisseur de l'ordre de 200 μm, et chacune des régions opposées de type N (2, 3) s'étend dans le bloc plan jusqu'à une profondeur de l'ordre de 30 μm.

4. Un dispositif semiconducteur d'absorption de transitoires selon l'une quelconque des revendications 1 à 3, caractérisé en ce que le silicium de type P (4) a une résistivité en volume dans la plage de 0,95 à 1,8 Ω cm$^{-3}$, et la résistivité en surface des régions de type N (2, 3) est dans la plage de 0,7 à 0,9 Ω cm$^{-2}$.

5. Un dispositif semiconducteur d'absorption de transitoires selon l'une quelconque des revendications 1 à 4, caractérisé en ce qu'il est combiné avec au moins un dispositif supplémentaire de ce type (1′) connecté en série avec le premier dispositif (1).

6. Un dispositif semiconducteur d'absorption de transitoires selon la revendication 5, caractérisé par la présence de deux dispositifs (1, 1′) connectés de cette manière, avec une trosième électrode (10) formée entre des régions de contact électrique (7a, 7b, 8′) des régions de type N (3, 2′) des deux dispositifs (1, 1′).

FIG.1

FIG. 2

FIG.3